# EUROPÄISCHE PATENTSCHRIFT

(11) **EP 1 053 583 B1**
(45) Veröffentlichungstag und Bekanntmachung des Hinweises auf die Patenterteilung: **09.05.2007**
(21) Anmeldenummer: 98966673.0
(22) Anmeldetag: 24.12.1998
(51) Int. Cl.: H02B 1/56, H05K 7/20

(54) **SCHALTSCHRANK MIT EINER KLIMATISIERUNGS-EINRICHTUNG**
CONTROL CABINET WITH AIR CONDITIONING DEVICE
ARMOIRE DE COMMANDE AVEC DISPOSITIF DE CLIMATISATION

(30) Priorität: 07.02.1998 DE 19804900
(43) Veröffentlichungstag der Anmeldung: 22.11.2000
(73) Patentinhaber: Rittal-Werk Rudolf Loh GmbH & Co. KG, 35745 Herborn (DE)
(72) Erfinder: NICOLAI, Walter, D-35418 Buseck 1 (DE); PAWLOWSKI, Adam, D-35713 Eschenburg (DE); PERLITZ, Harald, D-35690 Dillenburg (DE)
(74) Vertreter: Fleck, Hermann-Joseph
(86) Internationale Anmeldenummer: PCT/EP1998/008449
(87) Internationale Veröffentlichungsnummer: WO 1999/040658

(56) Entgegenhaltungen:
- EP-A- 0 312 372
- DE-C- 4 135 894
- DE-C- 19 609 794

## Beschreibung

Die Erfindung betrifft einen Schaltschrank mit einer Klimatisierungs-Einrichtung,die im Schaltschrank-Innenraum eingebaut ist, und die mit einem Luftführungskanal in räumlicher Verbindung mit dem Schaltschrank-Innenraum steht, und wobei der Schaltschrank-Innenraum mittels Seitenwänden und mindestens einer Schranktür verkleidet ist.

Ein derartiger Schaltschrank ist aus der DE 196 09 794 C1 bekannt. Aus diesem Dokument ist ein Schaltschrank bekannt, der einen Schrankkorpus und eine daran anscharnierte Schranktür aufweist. Die Schranktür trägt außenseitig ein Klimagerät, das von einer Abdeckhaube überdeckt ist. zwischen der Abdeckhaube und der Schranktür ist ein Sammelkanal gebildet, Durch diesen kann die für die Klimatisierung benötigte Umgebungsluft gefördert werden. Ein weiterer Schaltschrank ist aus dem Firmenprospekt Rittal-Handbuch 29, Seite 520 bekannt. Bei solchen Schaltschränken ist die Klimatisierungs-Einrichtung als Kühlgerät ausgebildet, das in einer beliebigen Höhenstellung im Schaltschrank-Innenraum montiert werden kann. Die Klimatisierungs-Einrichtung saugt erwärmte Luft aus dem Schaltschrank-Innenraum ab und führt sie einem Verdampfer eines Kühlkreislaufes zu. Hier wird das Temperaturniveau der Luft abgesenkt. Anschließend kann die klimatisierte Luft wieder mittels eines Lüfters in den Schaltschrank-Innenraum abgegeben werden.

In der DE 41 35 894 C1 ist ein Kühlgerät beschrieben, das sich in eine Seitenwand eines Schaltschrankes einbauen lässt. Das Kühlgerät weist ein Gehäuse auf, das aus einem Gehäuse-Außenteil und einem Gehäuse-Innenteil zusammengesetzt ist. In dem von dem Gehäuse-Außen- und -Innenteil umschlossenen Aufnahmeraum sind die Komponenten des Klimagerätes untergebracht. Bei dieser Anordnung wird die zu kühlende Innenluft aus vorbestimmten Bereichen aus dem Schaltschrank-Innenraum abgesaugt und durch die einzelnen Kühlaggregate des Kühlgerätes geleitet.

Die EP 0 312 372 zeigt einen Einbaulüfter, der im Innenraum eines Schaltschrankes plaziert werden kann. Dieses Kühlgerät weist einen Außenkreisleuf und einen Innenkreislauf auf. Der Außenkreislauf steht mit der Umgebung des Schaltschrankes in räumlicher Verbindung. Der Innenkreislauf weist einen Luftführungskanal mit einer Lufteintritts- und einer Luftaustrittsöffnung auf. Über die Lufteintrittsöffnung kann Luft aus dem Schaltschrank-Innenraum abgesaugt und anschließend gekühlt werden. Die gekühlte Luft wird dann über die Luftaustrittsöffnung in den Schaltschrank-innenraum abgegeben. Abhängig von den Einbaugegebenheiten im Schaltschrank kann das Kühlgerät höhenvariabel plaziert werden.

Es ist Aufgabe der Erfindung, einen Schaltschrank der eingangs erwähnten Art zu schaffen, mit dem eine effektive Klimatisierung der im Schaltschrank-Innenraum befindlichen Luft möglich ist.

Gelöst wird diese Aufgabe durch den charakterisierenden Teil von Anspruch 1.

Die beispielsweise stark erwärmte Luft aus dem Schaltschrank-Innenraum kann in dem Luftsammelkanal vorklimatisiert werden, wobei ein Wärmetausch mit der Umgebung über die Seitenwand stattfindet. Anschließend kann die vorklimatisierte Luft der Klimatisierungs-Einrichtung zugeführt und hier weiter gekühlt werden. Mit einer solchen Anordnung, bei der die Seitenwand als Wärmetauscher dienen kann, ist eine effektive Klimatisierung möglich. Insbesondere ist für die Klimatisierungs-Einrichtung nur eine geringe Kälteleistung erforderlich.

Die Zwischenwand ermöglicht einen flexiblen Einbau der Klimatisierung-Einrichtung. Diese kann wahlweise einer der Reihen von Durchbrüchen zugeordnet werden. über die anderen verbleibenden Durchbrüche lässt sich die Verbindung des Luftsammelkanales zu dem Schaltschrank-Innenraum herstellen.

Beispielsweise kann dabei die Luft aus dem Schaltschrank-Innenraum aus verschiedenen Ebenen abgesaugt werden. Vorteilhafterweise ist es hierbei vorgesehen, daß die Zwischenwand wenigstens drei Reihen von Durchbrüchen aufweist, wobei eine Reihe im oberen Deckenbereich, eine Reihe im unteren Bodenbereich und eine weitere Reihe im Mittelbereich der Zwischenwand angeordnet ist.

Um Luft gezielt aus einem bestimmten Bereich des Schaltschrankes absaugen bzw. in diesen abgeben zu können, ist es nach einer bevorzugten Ausgestaltungsvariante der Erfindung vorgesehen, daß wahlweise einer oder mehrere der Durchbrüche mittels Abdeckungen verschlossen werden können.

Eine mögliche Erfindungsvariante ist dadurch gekennzeichnet, daß die Klimatisierungs-Einrichtung mittels mindestens eines Lüfters erwärmte Luft aus dem Luftsammelkanal in den Luftführungskanal einsaugt und einem Wärmtauscher zuführt, und daß die, am Wärmetauscher klimatisierte Luft über einen oder mehrere Auslässe in den Schaltschrank-Innenraum abgebbar ist. Werden mehrere Auslässe verwendet, so sollten diese bevorzugt wahlweise verschließbar sein, so daß die Verbindung zum Schaltschrank-Innenraum nur an vorbestimmbaren Stellen stattfinden kann.

Eine leistungsfähige Klimatisierungs-Einrichtung zeichnet sich gemäß der Erfindung dadurch aus, daß sie ein Kühlgerät mit einem Verdampfer und einem Verflüssiger aufweist, wobei der Verdampfer im Luftführungskanal angeordnet ist und der Verflüssiger über einen Außenkreislauf mit der Umgebung in Verbindung steht, und daß die im Außenkreislauf geleitete Außenluft über Durchlässe in der Schranktür oder einer Seitenwand in die Umgebung abgebbar bzw. aus dieser ansaugbar ist. Damit eine gleichmäßige Kühlung des Schaltschrank-Innenraumes möglich ist, kann es vorgesehen sein, daß wenigstens zwei Seitenwänden Zwischenwände zugeordnet sind, und daß die Klimatisierungs-Einrichtung mit den zwischen, den Seiten- und den Zwischenwänden gebildeten, Luftsammelkanälen in räumlicher Verbindung steht.

Zur Unterstützung des Lufttransportes können erfindungsgemäß an den Durchbrüchen der Zwischenwand ein oder mehrere Lüfter angeschraubt werden.

Die Erfindung wird im folgenden anhand eines in den Zeichnungen dargestellten Ausführungsbeispieles näher erläutert. Es zeigen:
- Fig.1: in perspektivischer Seitenansicht und teilweise im Schnitt einen Schaltschrank mit einer darin eingebauten Klimatisierungs-Einrichtung und
- Fig.2: in Draufsicht einen schematisch dargestellten Horizontalschnitt durch die eingebaute Klimtisierungs-Einrichtung.

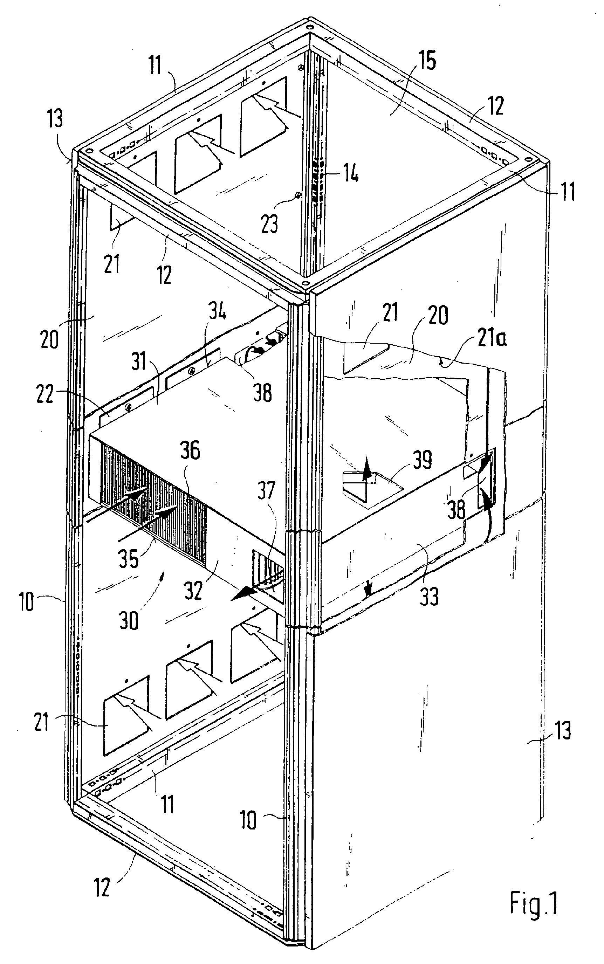

In der Fig. 1 ist ein Schaltschrank dargestellt, der ein Rahmengestell aufweist. Das Rahmengestell ist aus horizontalen und vertikalen Rahmenprofilen 10 und 11, 12 zusammengesetzt. Dabei bilden die horizontalen Rahmenprofile 11, 12 einen Boden- bzw. Deckrahmen, die miteinander über die vertikalen Rahmenprofile 10 verbunden sind. Das Rahmengestell ist mittels Seitenwänden 12, 15 verkleidet. Dabei bildet die Seitenwand 15 gleichzeitig die Rückwand des Schaltschrankes. Vorderseitig kann an dem Schaltschrank eine, aus Gründen der Übersichtlichkeit nicht dargestelllte, Schranktür anscharniert werden. Parallel beabstandet zu den beiden Seitenwänden 13 ist jeweils eine Zwischenwand 20 aufgestellt. Die Zwischenwand 20 überdeckt dabei das gesamte Feld, das von den seitlichen vertikalen Rahmenprofilen 10 und den als Tiefenstreben ausgebildeten horizontalen Rahmenprofilen 11 eingefaßt ist. Zwischen der Seitenwand 13 und der Zwischenwand 21 ist ein Luftsammelkanal 21 a gebildet. Dieser Luftsammelkanal 21 a steht über drei Reihen von Durchbrüchen 21 mit dem Schaltschrank-Innenraum in räumlicher Verbindung. Pro Reihe sind jeweils drei Durchbrüche 21 vorgesehen. Die Reihen sind auf verschiedenen Ebenen angeordnet, wobei die oberere Reihe im Deckenbereich, die untere Reihe im Bodenbereich und die mittlere Reihe im Mittelbereich des Schaltschrankes angeordnet ist. Zur Montagevereinfachung ist die Zwischenwand 20 sym-metrisch aufgebaut. Die einzelnen Durchbrüche 21 können wahlweise mit Abdeckungen 22 verschlossen werden.

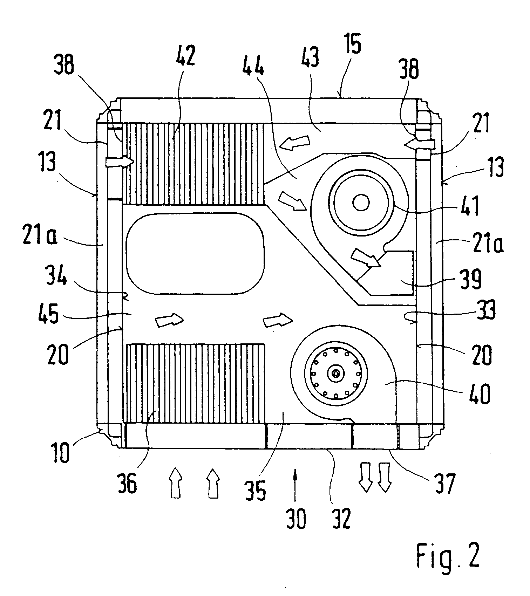

Im vorliegenden Ausführungsbeispiel ist eine Klimatisierungs-Einrichtung 30 im Mittenbereich des Schaltschrankes der entsprechenden Reihe von Durchbrüchen 21 zugeordnet. Die Klimatisierungs-Einrichtung 30 ist in einem Gehäuse untergebracht, das eine horizontale Deck- und eine Bodenwand 31 und 35 aufweist. Die Deckwand 31 ist mit der Bodenwand 35 über vertikale Seitenteile 33, 34 und eine Frontwand 32 verbunden. Die Seitenteile 33 sind mit Eintrittsöffnungen 38 versehen, die Zugang zu einem Luftführungskanal 43 (Siehe Fig. 2) im Inneren der Klimatisierungs-Einrichtung 30 schaffen. Die Eintrittsöffnungen 38 sind an einen Durchbruch 21 angeschlossen, so daß eine räumliche Verbindung des Luftsammelkanales 21a zu dem Luftführungskanal 43 entsteht.

In die Deck- und Bodenwand 31 und 35 sind Auslässe 39 eingearbeitet. Diese Auslässe 39 stehen ebenfalls in räumlicher Verbindung mit dem Luftführungskanal 43. Die Luftführung innerhalb dieses Luftführungskanales 43 wird im einzelnen später anhand der Fig. 2 erläutert. In die Frontwand 32 ist ein Verflüssiger 36 eingebaut, durch den Umgebungsluft strömen kann. Die Umgebungsluft wird über Öffnungen der Schranktür angesaugt, durch die Klimatisierungs-Einrichtung 30 geleitet und anschließend durch eine Austrittsöffnung 37 wieder in die Umgebung abgegeben.

Zur Verdeutlichung der Funktionsweise wird im folgenden auf die Fig. 2 Bezug genommen. Diese Zeichnung zeigt einen Horizontalschnitt durch die Klimatisierungs-Einrichtung 30. Die Fig. 2 veranschaulicht den Luftführungskanal 43, der sich an die Eintrittsöffnungen 38 anschließt. In dem Luftführungskanal 43 ist ein Verdampfer 42 eines Kältekreislaufes untergebracht. Im Anschluß an den Verdampfer mündet der Luftführungskanal 43 in einen weiteren Luftführungskanal 44. In diesem weiteren Luftführungskanal 44 ist ein Lüfter 41 untergebracht. Aus dem Innenraum des Schaltschrankes wird erwärmte Luft mittels des Lüfters 41 durch die Durchbrüche 21 in den Luftsammelkanal 21 a eingesaugt. Diese Luft gelangt über die Eintrittsöffnungen 38 in den Luftführungskanal 43 der Klimatisierungs-Einrichtung 30. Hier streicht sie an dem Verdampfer 42 vorbei, wodurch sie abgekühlt wird. Die so klimatisierte Luft wird mittels des Lüfters 41 anschließend wieder durch die Auslässe 39 in der Boden- und/oder der Deckwand 35, 31 in den Innenraum des Schaltschrankes gegeben.

Die Klimatisierungs-Einrichtung 30 weist weiterhin einen Außenkreislauf 45 auf, in dem der Verflüssiger 36 untergebracht ist. In dem Außenkreislauf 45 ist weiterhin ein Lüfter 40 eingebaut, der die Umgebungsluft über den Verflüssiger 36 ansaugt. An dem Verflüssiger findet ein Wärmeaustausch statt, der zur Kühlung der Luft im Schaltschrank-Innenraum genutzt wird. Die Außenluft wird im Anschluß an den Verflüssiger wieder über die Austrittsöffnungen 37 in die Umgebung abgegeben.

Erfindungsgemäß kann die Klimatisierungs-Einrichtung 30 auch an der dem Boden oder der Decke des Schaltschrankes zugeordneten Reihe von Durchbrüchen 21 befestigt werden. Wird die Klimatisierungs-Einrichtung 30 beispielsweise im Bodenbereich angebaut, so läßt sich der Auslaß 39, der in die Bodenwand 35 eingearbeitet ist, mit einer entsprechenden Abdeckplatte verschließen. Entsprechend kann auch der Auslaß 39 in der Deckwand 31 verschlossen werden, wenn die Klimatisierungs-Einrichtung im Deckenbereich des Schaltschrankes untergebracht ist. Die Klimatisierungs-Einrichtung 30 muß sich nicht über die gesamte Breite des Schaltschrankes erstrecken. Vielmehr kann sie auch entsprechend kleiner dimensioniert sein. Dann kann die Eintrittsöffnung 38 eines Seitenteiles 33, welches keiner Zwischenwand zugeordnet ist, Luft direkt aus dem Innenraum des Schaltschrankes absaugen. Alternativ kann diese Eintrittsöffnung 38 aber auch verschlossen werden.

## Patentansprüche

1. Schaltschrank mit einer Klimatisierungs-Einrichtung (30), die mit einem Luftführungskanal (43) in räumlicher Verbindung mit dem Schaltschrank-Innenraum steht, und wobei der Schaltschrank-Innenraum mittels Seitenwänden (13) und mindestens einer Schranktür verkleidet ist,
wobei die Klimatisierungs-Einrichtung (30) im Schaltschrank-Innenraum eingebaut ist,
dass beabstandet zur Seitenwand (13) eine Zwischenwand (20) angeordnet ist,
dass zwischen der Seitenwand (13) und der Zwischenwand (20) ein Luftsammelkanal (21a) geschaffen ist, der über Eintrittsöffnungen (38) mit dem Luftführungskanal (43) der Klimatisierungs-Einrichtung (30) und über einen oder mehrere Durchbrüche (21) mit dem Schaltschrank-Innenraum in räumlicher Verbindung steht, **dadurch gekennzeichnet,**
**dass** die Zwischenwand (20) mit mehreren Reihen von Durchbrüchen (21) versehen ist, wobei die Reihen in vertikaler Richtung zueinander beabstandet angeordnet sind, und
**dass** der Luftführungskanal (43) der Klimatisierungs-Einrichtung (30) über mindestens einen der Durchbrüche (21) an den Luftsammelkanal (21 a) angeschlossen ist.

2. Schaltschrank nach Anspruch 1,
**dadurch gekennzeichnet,**
**dass** die Zwischenwand (20) wenigstens drei Reihen von Durchbrüchen (21) aufweist, wobei eine Reihe im oberen Deckenbereich, eine Reihe im unteren Bodenbereich und eine weitere Reihe im Mittelbereich der Zwischenwand (20) angeordnet ist.

3. Schaltschrank nach Anspruch 1 oder 2,
**dadurch gekennzeichnet,**
**dass** wahlweise eine oder mehrere Durchbrüche (21) mittels Abdeckungen (22) verschlossen werden können.

4. Schaltschrank nach einem der Ansprüche 1 bis 3,
**dadurch gekennzeichnet,**
**dass** die Klimatisierungs-Einrichtung (30) mittels mindestens eines Lüfters (41) erwärmte Luft aus dem Luftsammelkanal (21 a) in den Luftführungskanal (43) einsaugt und einen Wärmetauscher (42) zuführt, und
**dass** die am Wärmetauscher (42) klimatisierte Luft über einen oder mehrere Auslässe (39) in den Schaltschrank-Innenraum abgebbar ist.

5. Schaltschrank nach einem der Ansprüche 1 bis 4,
**dadurch gekennzeichnet,**
**dass** die Klimatisierungs-Einrichtung mit einem Verdampfer (Wärmetauscher 42) und einem Verflüssiger (36) ist, wobei der Verdampfer im Luftführungskanal (43) angeordnet ist und der Verflüssiger (36) über einen Außenkreislauf (45) mit der Umgebung in Verbindung steht und
**dass** die Außenkreislauf geleitete Außenluft über Durchlässe in der Schranktür oder einer Seitenwand (13,15) in die Umgebung abgebbar bzw. aus dieser ansaugbar ist.

6. Schaltschrank nach einem der Ansprüche 1 bis 5,
**dadurch gekennzeichnet,**
**dass** wenigstens zwei Seitenwände (13) Zwischenwände (21) zugeordnet sind, und
**dass** die Klimatisierungs-Einrichtung (30) mit den zwischen den Seiten- und den Zwischenwänden (13 und 21) gebildeten Luftsammelkanälen (21 a) in räumlicher Verbindung steht.

7. Schaltschrank nach einem der Ansprüche 1 bis 6,
**dadurch gekennzeichnet,**
**dass** der Luftführungskanal (43) in mehrere Auslässe (39) mündet.

8. Schaltschrank nach einem der Ansprüche 1 bis 7,
**dadurch gekennzeichnet,**
**dass** an den Durchbrüchen (21) der Zwischenwand (20) ein oder mehrere Lüfter anbaubar sind, die einen Lufttransport zwischen dem Schaltschrank-Innenraum und dem Luftsammelkanal bewerkstelligen.

## Claims

1. Switchgear cabinet having an air-conditioning device (30) which is physically connected to the interior of the switchgear cabinet by an air-guide duct (43), and with the interior of the switchgear cabinet being lined by means of side walls (13) and at least one cabinet door, with the air-conditioning device (30) being installed in the interior of the switchgear cabinet, with an intermediate wall (20) being arranged at a distance from the side wall (13), and with an air-collection duct (21a) being provided between the side wall (13) and the intermediate wall (20), which air-collection duct is physically connected to the air-guide duct (43) of the air-conditioning device (30) via inlet openings (38) and to the interior of the switchgear cabinet via one or more apertures (21), **characterized in that** the intermediate wall (20) is provided with a plurality of rows of apertures (21), with the rows being arranged at a distance from one another in the vertical direction, and **in that** the air-guide duct (43) of the air-conditioning device (30) is connected to the air-collection duct (21a) via at least one of the apertures (21).

2. Switchgear cabinet according to Claim 1, **characterized in that** the intermediate wall (20) has at least three rows of apertures (21), with one row being arranged in the upper ceiling region, one row being arranged in the lower base region, and a further row being arranged in the central region of the intermediate wall (20).

3. Switchgear cabinet according to Claim 1 or 2, **characterized in that** one or more apertures (21) can optionally be closed by means of covers (22).

4. Switchgear cabinet according to one of Claims 1 to 3, **characterized in that** the air-conditioning device (30) sucks heated air into the air-guide duct (43) from the air-collection duct (21a) by means of at least one fan (41) and feeds said heated air to a heat exchanger (42), and **in that** the air which is conditioned at the heat exchanger (42) can be emitted into the interior of the switchgear cabinet via one or more outlets (39).

5. Switchgear cabinet according to one of Claims 1 to 4, **characterized in that** the air-conditioning device is provided with an evaporator (heat exchanger 42) and a condenser (36), with the evaporator being arranged in the air-guide duct (43) and the condenser (36) being connected to the surroundings via an external circuit (45), and **in that** the external air conducted in the external circuit can be emitted to the surroundings or sucked in from the surroundings via through-passages in the cabinet door or a side wall (13, 15).

6. Switchgear cabinet according to one of Claims 1 to 5, **characterized in that** at least two side walls (13) have associated intermediate walls (20), and **in that** the air-conditioning device (30) is physically connected to the air-collection ducts (21a) which are formed between the side walls (13) and the intermediate walls (20).

7. Switchgear cabinet according to one of Claims 1 to 6, **characterized in that** the air-guide duct (43) issues into a plurality of outlets (39).

8. Switchgear cabinet according to one of Claims 1 to 7, **characterized in that** one or more fans can be fitted at the apertures (21) in the intermediate wall (20), which fans cause air to be transported between the interior of the switchgear cabinet and the air-collection duct.

## Revendications

1. Armoire de commande avec un dispositif de climatisation (30), celui-ci étant en communication avec l'espace intérieur de l'armoire de commande par le biais d'un canal de guidage d'air (43), et l'espace intérieur de l'armoire de commande étant habillé au moyen de parois latérales (13) et d'au moins une porte d'armoire,
le dispositif de climatisation (30) étant monté dans l'espace intérieur de l'armoire de commande,
une paroi intermédiaire (20) étant disposée à distance de la paroi latérale (13),
un canal collecteur d'air (21a), qui communique avec le canal de guidage d'air (43) du dispositif de climatisation (30) par le biais d'ouvertures d'entrée (38) et avec l'espace intérieur de l'armoire de commande par le biais d'un ou de plusieurs ajours (21), étant créé entre la paroi latérale (13) et la paroi intermédiaire (20), **caractérisée en ce que**
la paroi intermédiaire (20) est munie de plusieurs rangées d'ajours (21), les rangées étant disposées à distance les unes des autres dans la direction verticale, et
**en ce que** le canal de guidage d'air (43) du dispositif de climatisation (30) est relié au canal collecteur d'air (21a) par le biais au moins de l'un des ajours (21).

2. Armoire de commande selon la revendication 1,
**caractérisée en ce que**
la paroi intermédiaire (20) est munie d'au moins trois rangées d'ajours (21), une rangée étant disposée dans la zone supérieure du plafond, une rangée dans la zone inférieure du plancher et une autre rangée dans la zone du milieu de la paroi intermédiaire (20).

3. Armoire de commande selon la revendication 1 ou 2,
**caractérisée en ce que**
un ou plusieurs ajours (21) peuvent au choix être fermés au moyen de couvercles (22).

4. Armoire de commande selon l'une des revendications 1 à 3,
**caractérisée en ce que**
le dispositif de climatisation (30) aspire de l'air réchauffé depuis le canal collecteur d'air (21a) au moyen d'au moins un ventilateur (41), le refoule dans le canal de guidage d'air (43) et l'introduit dans un échangeur de chaleur (42), et **en ce que** l'air climatisé dans l'échangeur de chaleur (42) peut être envoyé dans l'espace intérieur de l'armoire de commande par le biais d'une ou de plusieurs sorties (39).

5. Armoire de commande selon l'une des revendications 1 à 4,
**caractérisée en ce que**
le dispositif de climatisation est muni d'un évaporateur (échangeur de chaleur 42) et d'un condenseur (36), l'évaporateur étant disposé dans le canal de guidage d'air (43) et le condenseur (36) étant en relation avec l'environnement par le biais d'un circuit extérieur (45), et **en ce que** l'air extérieur guidé dans le circuit extérieur peut être refoulé vers l'environnement ou aspiré de celui-ci par le biais de passages dans la porte de l'armoire ou dans une paroi latérale (13, 15).

6. Armoire de commande selon l'une des revendications 1 à 5,
**caractérisée en ce que**
des parois intermédiaires (20) sont affectées à au moins deux parois latérales (13), et **en ce que**
le dispositif de climatisation (30) est en communication avec les canaux collecteurs d'air (21a) créés entre les parois latérales (13) et intermédiaires (20).

7. Armoire de commande selon l'une des revendications 1 à 6,
**caractérisée en ce que**
le canal de guidage d'air (43) débouche dans plusieurs sorties (39).

8. Armoire de commande selon l'une des revendications 1 à 7,
**caractérisée en ce que**
un ou plusieurs ventilateurs assurant un transport d'air entre l'espace intérieur de l'armoire de commande et le canal collecteur d'air peuvent être montés sur les ajours (21) de la paroi intermédiaire (20).
